# EUROPÄISCHE PATENTSCHRIFT

(11) **EP 0 510 555 B1**
(45) Veröffentlichungstag und Bekanntmachung des Hinweises auf die Patenterteilung: **26.07.1995**
(21) Anmeldenummer: 92106724.5
(22) Anmeldetag: 18.04.1992
(51) Int. Cl.: C30B 33/02, C30B 23/02, C30B 25/02, C30B 33/00, C30B 29/10, C30B 25/18, H01L 21/20

(54) **Verfahren zur Herstellung eines Schichtsystems und Schichtsystem**
Process for the production of a layer system and layer system
Procédé de production d'un système stratifié et système stratifié

(30) Priorität: 23.04.1991 DE 4113143
(43) Veröffentlichungstag der Anmeldung: 28.10.1992
(73) Patentinhaber: FORSCHUNGSZENTRUM JÜLICH GMBH, 52425 Jülich (DE)
(72) Erfinder: Mantl, Siegfried, Dr., W-5170 Jülich (DE); Bay, Helge, Dr., W-5172 Linnich (DE)

(56) Entgegenhaltungen:
- DE-A- 2 346 198
- DE-A- 2 426 493

## Beschreibung

Die Erfindung bezieht sich auf ein Verfahren zur Herstellung eines Schichtsystems für elektronische Bauelemente aus wenigstens zwei Schichten aus halbleitenden, metallischen oder isolierenden Materialien, bei dem eine erste Materialkomponente zur Bildung der untersten, einkristallinen Schicht auf einem geeigneten Substrat und sodann weitere Komponenten zur Bildung weiterer Schichten auf der jeweils vorherigen Schicht abgeschieden werden. Die Erfindung bezieht sich ferner auf ein Schichtsystem gemäß dem Oberbegriff des Anspruchs 11 und ein Mehrfachschichtsystem gemäß dem Oberbegriff des Anspruchs 12.

Derartige Schichtsysteme sind geeignet für elektronische, elektrooptische, optische oder magnetische Bauelemente.

Zur Durchführung dieser bekannten Verfahrensweise eignen sich im Prinzip alle gängigen Techniken für Dünnschichtherstellung, die Schichtwachstum eines Mehrstoffsystems bei geeigneten Temperaturen und gut kontrollierten Abscheideraten ermöglichen. Insbesondere geeignet sind Molekularstrahlepitaxie, Ultrahochvakuum (UHV)-Aufdampfen, und CVD (chemical vapor deposition).

Zur Bildung unterschiedlicher, aneinander anliegender Schichten wurde bisher so verfahren, daß zunächst eine Komponente (auf einem Substrat oder einer vorher gebildeten Schicht) und sodann zur Bildung der darüberliegenden Schicht die nächste Komponente d.h. jede Komponente separat abgeschieden wurde. Zwar gelingt auf diese Weise die Herstellung von Mehrschichtsystemen mit scharf voneinander getrennten Schichten. Das Ziel, außer der untersten Schicht auch die oberen Schichten als einkristalline Schichten zu erzeugen, wird dabei jedoch nicht erreicht, wenn die Zwischenschicht nicht auch einkristallin (gitterangepaßt) aufwächst. So ist es beispielsweise bisher nicht möglich, einkristalline Silicide guter Qualität auf (100) Si herzustellen. Auch das Überwachsen mit Si, um vergrabene Leiterbahnen oder spezielle Bauelemente zu erzeugen, ist in dieser Hinsicht problematisch.

Die Herstellung von einkristallinen Siliciden relativ guter Qualität insbesondere auf (100) Si wurde bisher lediglich mittels der Hochdosisimplantation durchgeführt (A.E. White, K.T. Short, R.C. Dynes, J.P. Garno an J.M. Gibson, Appl. Phys. Lett. 50 (1987) 95).

Auch bei der bisher industriell eingeführten Methode zur Herstellung vergrabener Isolationsschichten (SiO₂ in Si) wird die Hochdosisimplantation von Sauerstoffionen in Si-Scheiben eingesetzt (K. Izumi, M. Doken and H. Arigoshi, Electron. Lett. 14 (1978) 593). Diese bekannte Verfahrensweise erfordert jedoch einen sehr großen Aufwand und kann die durch die Implantation erzeugten Gittereffekte und relativ hohe Versetzungsdichte im Si nicht vermeiden.

Es ist daher Aufgabe der Erfindung, ein Verfahren der eingangs bezeichneten Art zu schaffen, daß es auf einfache und kostengünstigere Weise als bisher ermöglicht, mit Komponenten, mit denen es gelingt, auf einem geeigneten Substrat eine einkristalline Schicht zu erzeugen, obere, einkristalline Schichten guter Qualität auch dann herzustellen, wenn diese durch eine nicht einkristalline oder amorphe Zwischenschicht getrennt sind.

Aufgabe der Erfindung sind außerdem Schichtsysteme mit einkristallinen Si-Schichten guter Qualität bei mehr als drei Schichten, sowie Mehrfachschichtsysteme aus wenigstens vier Schichten mit einkristallinen oberen Schichten.

Diese Aufgabe wird erfindungsgemäß dadurch gelöst, daß bei zwei aneinander anliegenden Schichten, von denen wenigstens die eine epitaktisch aufwächst, die die epitaktische Schicht bildende und die die andere Schicht bildende, andere Komponente (B), die nicht vollständig ineinander löslich sind, in einem die epitaktisch wachsende Schicht (A) teilweise und die andere Schicht ganz erfassenden Übergangsbereich gemeinsam abgeschieden werden, wobei bei der Abscheidetemperatur die andere Komponente (B) allein oder beide Komponenten (A und B) miteinander eine stabile oder metastabile Phase bilden und wobei der Volumenanteil der anderen Komponente (B) in unterstöchiometrischer Menge vorliegt und beide Komponenten in ihrer auf den Übergangsbereich bezogenen Volumenkonzentration oder ihrem Konzentrationsgefälle so bemessen sind, daß sich in der epitaktischen Schicht des Übergangsbereichs Präzipitate der stabilen und mestabilen Phase bilden, und daß bei einer anschließenden Temperung bei einer Temperatur, bei der sich eine hinreichende Löslichkeit und Diffusionskonstante der Präzipitate in der epitaktischen Matrix einstellen, eine diffusive Umverteilung der stabilen Phase erfolgt, bei der durch Koaleszens der Präzipitate die separaten, aneinander anliegenden Schichten entstehen, von denen die andere aus der stabilen Phase oder aus einer aus der metastabilen Phase entstehenden stabilen Phase gebildet ist.

Zwei aneinander anliegende Schichten können die beiden ersten Schichten, also die direkt auf dem Substrat aufwachsende, einkristalline und die darüberliegende, aber auch jedes weitere Paar aneinander anliegender Schichten sein, also beispielsweise die zweite und die dritte Schicht. Voraussetzung ist, daß von jedem Paar anliegender Schichten mindestens eine einkristallin aufwächst. Die "andere" Schicht, die aus den zusammenwachsenden Präzipitaten entsteht, wird aus zumindest einem Anteil der jeweils "anderen" Komponenten B gebildet.

Gemeinsames Abscheiden der Komponente heißt dabei sowohl gleichzeitiges Abscheiden als auch Abscheiden in wechselnder Folge.

Geeignet für die Durchführung des erfindungsgemäßen Verfahrens sind Komponenten A, B und C, die bei der Herstellungsbedingungen, also bei der Abscheidung und während des Temperns, nicht völlig ineinander löslich sind und bei der Abscheidetemperatur miteinander eine stabile oder metastabile Phase bilden, außerdem "andere" Komponenten B, die alleine in der einkristallinen Matrix eine stabile Phase bildet.

Derartige Komponenten können Elemente wie beispielsweise Si oder Ge, binäre Mischkristalle sein wie SiGe, aber auch Verbindungshalbleiter wie GaAs. So kann die Komponente A beispielsweise Si, die Komponente B Co und die Komponente C wieder Si sein, so daß das Schichtpaket Si/CoSi₂/Si (A/ABₓ/A) entsteht. Aber auch beispielsweise die Schichtenbildung Si/SiO₂/Si (A/ABₓ/A) aus Komponete Si und Komponente O₂ ist möglich.

So sind beispielsweise als Schichtsysteme, die nach dem erfindungsgemäßen Verfahren herstellbar sind, zu nennen:
Epitaktische Silicide in Si wie z.B. CoSi₂, NiSi₂, CrSi₂, FeSi₂, IrSi₂, ...
Amorphe Isolationsschichten in Si wie z.B. SiO₂, Si₃N₄, ...
Polykristalline Halbleiter in Si wie z.B. SiC, ...
Epitaktische Metallisierungsschichten in GaAs bzw. InP wie z.B. CoAl, NiAl, ...
Metallische Systeme wie z.B. Ni₃Al (y-Phase) in Ni.

Um zu einem Schichtsystem zu gelangen, bei dem sich die unterste von der oberhalb der Zwischenschicht befindlichen Schicht unterscheidet, wird so verfahren, daß die die epitaktisch wachsende Schicht bildende Komponente A während des gemeinsamen Abscheidens der Komponenten durch eine weitere, ebenfalls eine epitaktisch wachsende Schicht bildende Komponente C teilweise oder ganz ergänzt wird.

So kann die Komponente A Si, die Komponente B O₂ und die Komponente C Ge sein, so daß das Schichtpaket Si/SiO₂/SiGe (A/ABₓ/AC oder A/ABₓ/C) entsteht.

Als Beispiel dafür, daß Komponente A ein Mischkristall ist, sind als Schichtsystem SiGe_{0.25}/SiO₂/SiGe_{0.25} oder der Verbindungshalbleiter GaAs/CoAl/GaAs zu nennen.

Auch ist es möglich, daß die entstehende Zwischenschicht aus einer Komponente B (z.B. SiO₂) entsteht, die nicht mit der Komponenten A (z.B. Ge) reagiert. Dann bilden sich beispielsweise die Schichtpakete Ge/SiO₂/Ge oder auch Si/CaF₂/Si. In diesen Fällen bestehen die stabilen Phasen aus SiO₂ bzw. CaF₂.

Die "andere" Komponente B, die mit den beiden Komponenten A und C jeweils getrennt, zusammen oder alleine eine stabile oder metastabile Phase bildet, kann, aber muß nicht in der Lage sein, auf einer einkristallinen, unteren Schicht epitaktisch aufzuwachsen.

Bei der Abscheidetemperatur bilden sich sofort Ausscheidungen bzw. Präzipitate der stabilen oder metastabilen Phase, ohne daß die einkristalline Matrix gestört wird. Die Struktur dieser Präzipitate kann einkristallin, polykristallin oder amorph sein. Maßgeblich ist dabei, daß während des Abscheidens der "anderen" Komponente B die Komponente A oder Komponente C, die gemeinsam mit A oder alleine die weitere anliegende Schicht bildet, epitaktisch durchwachsen. Die übernächste (dritte, fünfte...) Schicht ist somit bereits im Entstehen, während die vorherige (zweite, vierte...) noch nicht vollendet ist. Dadurch wird erreicht, daß ggfs. nicht nur die auf der unteren einkristallinen Schicht A aus der stabilen oder metastabilen Phase entstehende Schicht ABₓ, sondern auch die weitere, anliegende Schicht A (oder C oder AC) als einkristalline Schicht guter Qualität entsteht.

Auf diese Weise ist es möglich, ein Schichtsystem herzustellen, bei dem zwischen zwei einkristallinen Schichten (A und A, A und C oder auch A und AC) guter Qualität eine Zwischenschicht ABₓ oder AC_{y}Bₓ, die einkristallin, aber auch polykristallin oder amorph sein kann, eingebettet ist.

Da die Durchführung des erfindungsgemäßen Verfahrens darauf beruht, daß zunächst die in die einkristalline Matrix eingebetteten Präzipitate erzeugt werden und sodann in einer Temperaturbehandlung eine diffusive Umverteilung der Präzipitate bis zur Bildung der festen Schichten von statten geht, sind die einzelnen Verfahrensparameter hierauf einzustellen.

So ist bei der Wahl der einzustellenden Temperatur, die entweder in situ in der Depositionsanlage oder extra situ im Rohrofen oder im Schnellheizofen (RTP rapid thermal processing) erfolgen kann, darauf zu achten, daß Löslichkeit und Diffusionskonstante der Präzipitate in der epitaktischen Matrix bei der vorgesehenen Zeit der Temperaturbehandlung hinreichen, um die Bildung der Schicht abzuschließen. Dies wird je nach der Wahl der einzelnen Komponente in einzelnen Vorversuchen zu optimieren sein. Beim System Si/CoSi₂/Si liegt die Temperatur bei einer vorgesehenen Zeit der Temperaturbehandlung von 60 Sekunden bei etwa 1000°C.

Bei der Verteilung der Präzipitate in der epitaktischen Schicht kommt es darauf an, daß sie derart vorgenommen wird, daß die Koaleszenz in Richtung auf die zu bildende, andere Schicht hin erfolgt. Da sich innerhalb des Übergangsbereichs in der einkristallinen Schicht der Komponenten A (ggfs. auch AC) ein Konzentrationsgradient einstellt, hat dies zur Folge, daß die größeren Präzipitate insbesondere im Bereich höherer Konzentration auf Kosten der kleinen am Rande wachsen (Oswald-Reifung). Die Vergröberung führt zur Koaleszenz der Präzipitate und schließlich zur Schichtbildung, wodurch eine Minimierung der Grenzflächenenergien erzielt wird.

Zweckmäßig ist dabei, daß der Übergangsbereich unter Berücksichtigung der Diffusionslängen der diffundierenden Komponenten B bemessen wird. Da Ausscheidungen in einer Matrix thermodynamisch instabil sind, erfolgt Vergröberung und Koalezenz und somit Schichtwachstum auch bei konstanter Konzentration und Größenverteilung, wenn die Schichtdicke des Übergangsbereiches bei statistischer Größenverteilung nur klein genug gehalten wird. In der Regel reicht eine Volumenkonzentration der stabilen bzw. metastabilen Phase von ca 60 % der stöchiometrischen Menge im Übergangsbereich aus, um zum Ziel zu gelangen.

Es kann jedoch zweckmäßig sein, daß die andere Komponente B von der epitaktisch aufwachsenden Schicht A oder C zur Mitte des Übergangsbereiches hin mit zunehmender Konzentration abgeschieden wird. Dadurch setzt ein Materialtransport der stabilen oder metastabilen Phase in Richtung auf deren hohe Konzentration ein. Dabei handelt es sich bei der "Mitte" selbstverständlich um keine geometrische Mitte, sondern um einen mittleren Bereich.

Auch kann es zweckmäßig sein, daß die andere Komponente B von der epitaktisch aufwachsenden Schicht zur Mitte der anderen Schicht hin mit zunehmender Größe der Präzipitate abgeschieden wird.

Bei beiden Verfahrensvarianten bildet sich in der einkristallinen Matrix ein Konzentrationsgefälle aus, das die Präzipitate zur zu bildenden Schicht hin gelangen läßt.

Das Konzentrationsprofil bzw. die Größenverteilung kann symmetrisch oder unsymmetrisch sein. Wichtig ist, daß Konzentration (Dichte) und Größenvertellung der Präzipitate im Konzentrationsmaximum der anderen Komponenten B vor und/oder während der Temperung die Perkolationsschwelle überschreitet. Diese liegt in der Regel bei der halben Stöchiometrie der stabilen oder metastabilen Phase. Die obere Grenze wird dabei durch den maximalen Flächen(Volumen)anteil der Präzipitate bestimmt, der ein epitaktisches Wachstum der Komponente A (und ggfs.C) noch zuläßt.

Selbstverständlich ist die Gesamtmenge der auszuscheidenden Menge an stabiler oder metastabiler Phase so zu bemessen, daß diese Menge zur Bildung der Schicht hinreicht.

Die Erzeugung zunehmender oder abnehmender Konzentration der stabilen oder metastabilen Phase oder der beabsichtigten Größenverteilung der Präzipitate kann wahlweise oder gemeinsam durch Variieren der Abscheidetemperatur oder der Abscheiderate vorgenommen werden. Die Variation der Abscheidetemperatur dient dabei zur Erzeugung größerer oder kleinerer Präzipitate. Die Variation der Abscheiderate wird zur Erzeugung eines Konzentrationsprofils eingesetzt.

Dabei hat sich gezeigt, daß die Zunahme oder Abnahme der Größenverteilung oder der Konzentration sowohl kontinuierlich als auch in Stufen erfolgen kann. Maßgeblich ist dabei, daß bei anschließender Temperaturbehandlung die Präzipitate zur zu bildenden Schicht hin gelangen. Aus dieser Bedingung ergibt sich auch die Bemessung des Übergangsbereichs bzw. der Zeit der gemeinsamen Abscheidung der Komponenten.

Selbstverständlich ist es möglich, während der Schichtenbildung zusätzlich Dotierungsstoffe abzuscheiden, um zu dotierten Schichten zu gelangen.

Da der erfindungsgemäße Abscheidungsprozeß wiederholt variiert werden kann, ist es möglich, Doppel- oder Vielfachschichten herzustellen.

Durch Abscheidung auf litographisch vorstrukturierten Proben ist laterale in situ Strukturierung, z.B. für Gatestrukturen in Metall-Basis-Transistoren herstellbar.

Das Verfahren gemäß der Erfindung ermöglicht insbesondere vergrabene Schichten, die als metallische Leiterbahnen, Isolationsschichten oder optische Wellenleiter eingesetzt werden, herzustellen. Dadurch wird eine drei-dimensionale Integration von Bauelementen möglich.

Das erfindungsgemäße Verfahren ermöglicht außerdem die Abscheidung auf großen Flächen (z.B. Si-Scheiben mit einem Durchmesser von 100 - 200 mm). Dadurch ist auch ein hoher Durchsatz möglich.

Die Aufgabe gemäß der Erfindung wird, wie aus obigen Ausführungen zu entnehmen ist, durch ein Schichtsystem aus wenigstens drei Schichten mit einkristallinen Si-Schichten gelöst, bei dem ab der zweiten Schicht von je zwei aneinander anliegenden Schichten eine der Schichten eine einkristalline Struktur mit einer Versetzungsdichte von maximal 10⁴ cm⁻² aufweist. Diese Kristallinität übertrifft die Güte der bekannten SIMOX-Wafer. Die Erfindung löst ferner die Aufgabe, neue Mehrfachschichtsystem mit wenigstens vier Schichten aus halbleitenden, metallischen oder isolierenden Materialien mit einkristallinen Schichten in wenigsten ungerader Folge zu schaffen. Bei diesen Mehrfachschichtsystemen gemäß der Erfindung weist - abgesehen von den ersten Schichten - ab der dritten Schicht von je zwei aneinander anliegenden Schichten mindestens eine der Schichten eine einkristalline Struktur auf (in der Regel die dritte, fünfte usf.), die für elektronische, elektrooptische, optische oder magnetische Bauelemente geeignet ist.

### Ausführungsbeispiele:

Die nachstehend beschriebenen Ausführungsbeispiele zeigen die Herstellung der Schichtsystemtypen A/ABₓ, A/ABₓ/A, A/B/A, A/B/AC

### Ausführungsbeispiel 1 (Typ A/ABₓ/A)

Herstellung von einkristallinem Kobaltsilizid (CoSi₂) in (100) oder (111) orientiertem Silizium. (Komponente A≡Si, Komponente B≡Co, Schicht ABₓ≡CoSi₂)

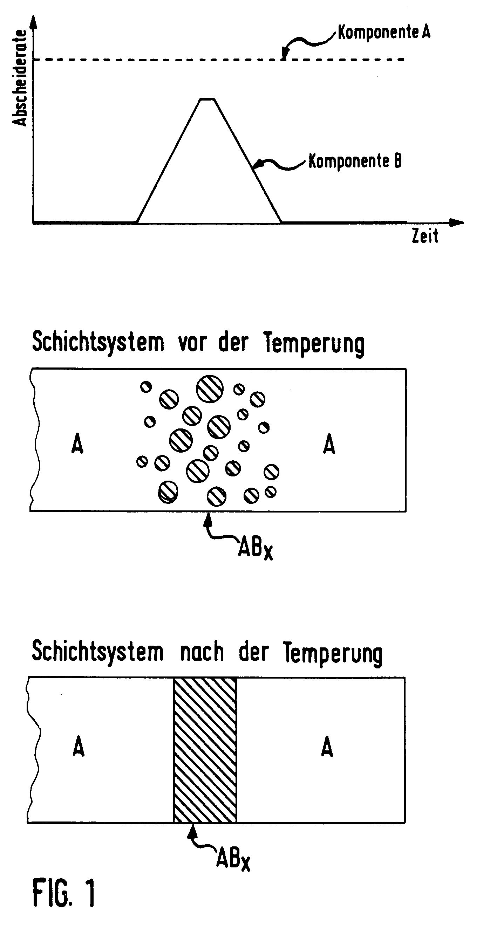

Nach der üblichen Waferreinigung wurde erst in einer Ultrahochvakuumanlage mit Elektronenstrahlverdampfung Si auf dem auf ca. 500°C geheizten Si-Substrat epitaktisch mit einer Rate von 0,2 nm/s abgeschieden. Bei laufender Si-Quelle wurde Co aus einer zweiten Quelle verdampft. Die Co-Aufdampfrate wurde so geregelt, daß ein etwa dreieckiges (siehe Figur 1) Co-Konzentrationsprofil entstand.

Die maximale Co-Konzentration betrug etwa 25 % (die theoretische Perkolationsschwelle liegt etwa bei der halben Co-Konzentration von CoSi₂ (33,3 %) d.h. bei 17 %). Für die 100 nm dicke CoSi₂-Schicht betrug die Halbwertsbreite des Konzentrationsprofils etwa 200 nm. Diese Halbwertsbreite und die maximale Konzentration des Tiefenprofils bestimmten nach dem nachfolgenden Temperschritt die Schichtdicke des Silizids. Der Übergangsbereich erstreckt sich somit in die beiden anliegenden Si-Schichten und umfaßt die gesamte Zwischenschicht.

Durch die Substrattemperatur von 550°C reagiert das auftreffende Co sofort mit Silizium und bildet CoSi₂₋ Ausscheidungen (Präzipitate). Die Substrattemperatur und die Aufdampfrate bestimmten die Ausscheidungsgröße.

Nach 60 s Tempern bei 1000°C enstand eine einkristalline CoSi₂ Schicht, eingebettet in einkristallines (100) Si (Si/CoSi₂/Si). CoSi₂ kristallisiert in der CaF₂-Struktur mit einer Gitterfehlanpassung von 1,2 %.

Die Einkristallinität der Heterostruktur ist von hoher Qualität und für elektronische Bauelemente geeignet. Die vergrabenen Disilizidschichten zeichnen sich durch kleinen elektrischen Widerstand aus (∼ 14 »Ωcm bei Raumtemperatur) und bilden einen Schottky-Kontakt hoher Qualität.

In das Si kann selbstverständlich während des Wachstums ein beliebiges Dotierprofil aus einer weiteren Verdampferquelle oder Effusionszelle eingebracht werden. (z.B. Ph)

### Ausführungsbeispiel 2 (Typ A/ABₓ) (Komponente A≡Si (100), Komponente B≡CoSi₂)

Es wurde wie im Ausführungsbeispiel 1 beschrieben vorgegangen, jedoch wurde der Abscheidevorgang mit Erreichen des Maximums beendet. CoSi₂ entstand somit nach der Temperaturbehandlung als Oberflächenschicht auf (100) Si. (Schichtsystem Si/CoSi₂).

### Ausführungsbeispiel 3 (Typ A/B/A)

Herstellung einer vergrabenen SiO₂ Schicht in einkristallinem Si (SOI Silicon on insulator-Strukturen).
(Komponente A≡Si, Komponente B≡SiO₂, Schicht B≡SiO₂)
Wie in Ausführungsbeispiel 1 beschrieben, wurde zunächst Si epitaktisch auf einer Siliziumscheibe bei geeigneter Wachstumstemperatur abgeschieden. Dann wurde SiO₂ zusätzlich verdampft, so daß ein etwa dreieckförmiges Konzentrationsprofil (siehe Figur 1) mit einer Halbwertsbreite von 100 nm entstand. Das SiO₂ wurde dabei in Form von amorphen Ausscheidungen in das einkristalline Si eingelagert.

Die SiO₂-Konzentration überschritt im Maximum des Profils den Wert von 50 %. (etwa 75 %)
Das einkristalline Si wurde vor der Temperbehandlung mit einer SiO₂ Schutzschicht (z.B. 200 nm dick) abgedeckt.

Die Temperaturbehandlung erfolgte bei einer Temperatur von über 1300°C über 6 Stunden. Es entstand das Schichtsystem Si/SiO₂/Si.

Die eingebettete SiO₂-Schicht ist eine dielektrische Isolationsschicht hoher Qualität. Das Oberflächen-Silicium ist einkristallin und hat eine für elektronische Bauelemente geeignete Qualität.

Wird das SiO₂ Konzentrationsprofil mehrfach in bestimmten Abständen wiederholt, entstehen Mehrfachschichten.

### Ausführungsbeispiel 4 (Typ A/ABₓ/A)

Herstellung einer vergrabenen SiO₂ Schicht in einkristallinem Si.

Im Unterschied zu Ausführungsbeispiel 3 wurden Si und SiO₂ mittels Gasphasenepitaxie aus SiH₄ und O₂ in einem CVD-Reaktor hergestellt. (Komponente B≡O₂)

### Ausführungsbeispiel 5 (Typ A/ABₓ/AC) (Komponente A=Si, Komponente B=SiO₂, Komponente C=Ge)

Herstellung eines Schichtsystems mit mehr als 2 Komponenten: Epitaktische Si-Ge_{y} Schichten auf mit vergrabenem SiO₂ in (100) Si.

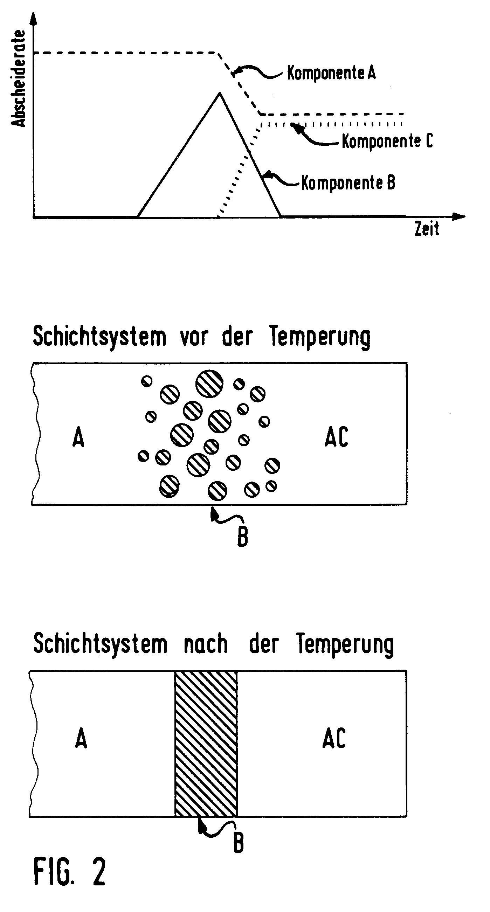

Wie in Beispiel 3 wurde Si und SiO₂ abgeschieden. Nach Erreichen des SiO₂ Konzentrationsmaximums wurde der Si-Fluß reduziert und Ge aus einer weiteren Quelle mit zunehmendem Fluß abgeschieden entsprechend Figur 2. SiO₂ liegt wieder in Ausscheidungen (Präzipitaten) vor. Die SiO₂ Ausscheidungen reagieren nicht mit Ge. Nach der Temperaturbehandlung ist die amorphe SiO₂-Schicht zwischen einkristallinem Si und einem einkristallinen Mischkristall Si-Ge der gewünschten Konzentration eingebettet (Schicht system Si/SiO₂/SiGe_{y}; mit z.B. y=0.25).

### Ausführungsbeispiel 6 (Typ A/B/A)

Komponente A=GaAs, Komponente B=CoAl Herstellung einer einkristallinen Metallisierungsebene (CoAl) in dem Verbindungshalbleiter GaAs.

GaAs wurde in einer Molekularstrahlepitaxie (MBE)-Anlage bei einer Wachstumstemperatur von 500°C auf einem (100) GaAs Substrat abgeschieden. Die Metalle Co und Al wurden im Verhältnis 1:1 bei laufender GaAs Abscheidung aus Elektronenstrahlverdampfern mit erst zunehmender und dann abnehmender Rate abgeschieden, so daß ein CoAl-Konzentrationsprofil in GaAs mit einem maximalen Konzentrationsverhältnis (CoAl):(GaAs) von ca. 75 % entstand. Die Halbwertsbreite des Konzentrationsprofils betrug ∼ 150 nm. Auf das Schichtsystem wurde vor dem Temperschritt eine Passivierungsschicht aufgebracht. Durch 1/2-stündiges Tempern bei 800°C wurde ein einkristallines Schichtsystem erzeugt. Sowohl die GaAs Oberfläche als auch die vergrabene CoAl Schicht sind einkristallin. CoAl (CsCl Struktur) hat eine Gitterfehlanpassung von 1.2 % in GaAs.

Wird eine zweite CoAl Schicht hergestellt, stellt das Schichtsystem einen mit metallischen Elektroden (CoGa) versehenen elektrooptischen Wellenleiter (GaAs) dar. (vertikale Bauweise)

In der Zeichnung wird in Zeitdiagrammen die erfindungsgemäße Verfahrensweise zusammen mit einer chematischen Darstellung der während des Abscheidevorgangs entstehenden Schichten und der nach der Temperaturbehandlung hergestellten Schichten wiedergegeben.

Es zeigen
- Figur 1: die Herstellung eines Schichtpakets des Typus A/ABₓ/A (z.B. Si/CoSi₂/Si)
- Figur 2: die Herstellung eines Schichtpakets des Typus A/B/AC (z.B. Si/SiO₂/SiGe_{0.25} mit SiO₂ als Komponente B)
- Figur 3: die Herstellung eines Schichtpakets des Typus A/ABₓ/AC (z.B. Si/SiO₂SiGe_{0.25} mit O₂ als Komponente B)

Wie aus dem Zeitdiagramm aus Figur 1 hervorgeht, wird zunächst die Komponente A für eine Zeit lang alleine abgeschieden. Danach wird die Komponente B mit ansteigender Konzentration bis zu einem Maximum, das in der Mitte der zu bildenden Schicht ABₓ liegt, und danach mit abnehmender Konzentration abgeschieden. Die Abscheiderate für die Komponente A bleibt gleich.

Die mittlere Darstellung der Figur 1 zeigt das Vorliegen der Präzipitate in der einkristallinen Matrix A, die durchgehend einkristallin gebildet wird. Die untere Darstellung zeigt das fertige Schichtsystem aus A/ABₓ/A.

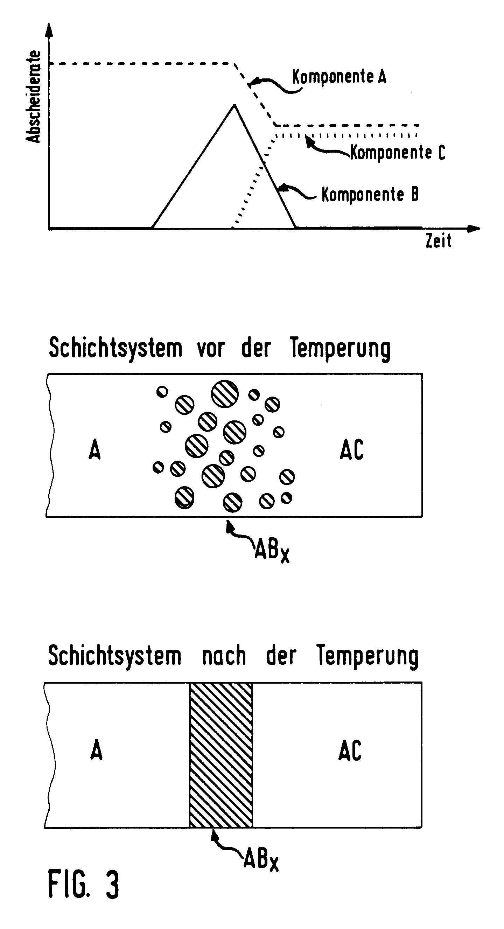

Auch das Zeitdiagramm der Figuren 2 und 3 gibt an, daß die Komponente A zunächst alleine, dann aber zusammen mit der in ihrer Konzentration zunächst ansteigenden und dann abfallenden Komponente B abgeschieden wird. Der Verlauf der Abscheiderate für die Komponente B entspricht dem im Diagramm der Figur 1 gezeigten Verlauf. Im Beispiel der Figur 2 entsteht die mittlere Schicht alleine aus B, während es im Beispiel der Figur 3 zur Bildung von ABₓ kommt.

Etwa an dem Konzentrationsmaximum der Komponenten B wird jedoch die Abscheiderate der Komponenten A verringert, während entsprechend eine Abscheidung der Komponente C einsetzt. Die Komponente A wird somit teilweise durch die Komponente C ersetzt.

Die übrigen Darstellungen in den Figuren 2 und 3 zeigen wieder das gebildete Schichtsystem mit den Präzipitaten und das fertige Schichtsystem nach der Temperaturbehandlung.

## Patentansprüche

1. Verfahren zur Herstellung eines Schichtsystems aus wenigstens zwei Schichten aus halbleitenden, metallischen oder isolierenden Materialien, bei dem eine erste Materialkomponente (A) zur Bildung der untersten, einkristallinen Schicht auf einem geeigneten Substrat und sodann weitere Komponenten zur Bildung weiterer Schichten auf der jeweils vorherigen Schicht abgeschieden werden,
**dadurch gekennzeichnet,**
daß bei zwei aneinander anliegenden Schichten, von denen wenigstens die eine epitaktisch aufwächst, die die eptaktische Schicht bildende und die die andere Schicht bildende, andere Komponente (B), die nicht vollständig ineinander löslich sind, in einem die epitaktisch wachsende Schicht (A) teilweise und die andere Schicht ganz erfassenden Übergangsbereich gemeinsam abgeschieden werden, wobei bei der Abscheidetemperatur die andere Komponente (B) allein oder beide Komponenten (A und B) miteinander eine stabile oder metastabile Phase bilden und wobei der Volumenanteil der anderen Komponente (B) in unterstöchiometrischer Menge vorliegt und beide Komponenten in ihrer auf den Übergangsbereich bezogenen Volumenkonzentration oder ihrem Konzentrationsgefälle so bemessen sind, daß sich in der epitaktischen Schicht des Übergangsbereichs Präzipitate der stabilen und metastabilen Phase bilden, und daß bei einer anschließenden Temperung bei einer Temperatur, bei der sich eine hinreichende Löslichkeit und Diffusionskonstante der anderen Komponente (B) in der epitaktischen Matrix einstellt, eine diffusive Umverteilung der stabilen Phase erfolgt, bei der durch Koaleszens der Präzipitate die separaten, aneinander anliegenden Schichten entstehen, von denen die andere aus der stabilen Phase oder aus einer aus der metastabilen Phase entstehenden stabilen Phase gebildet ist.

2. Verfahren nach Anspruch 1,
**dadurch gekennzeichnet,**
daß die die epitaktisch wachsende Schicht bildende Komponente (A) während des gemeinsamen Abscheidens der Komponenten durch eine weitere, ebenfalls eine epitaktisch wachsende Schicht bildende Komponente (C) teilweise oder ganz ergänzt wird.

3. Verfahren nach Anspruch 1 oder 2,
**dadurch gekennzeichnet,**
daß der Übergangsbereich unter Berücksichtigung der Diffusionslängen der diffundierenden Komponente (B) bemessen ist.

4. Verfahren nach Anspruch 3,
**dadurch gekennzeichnet,**
daß die andere Komponente (B) von der epitaktisch aufwachsenden Schicht (A oder C) zur Mitte des Übergangsbereiches hin mit zunehmender Konzentration abgeschieden wird.

5. Verfahren nach Anspruch 3,
**dadurch gekennzeichnet,**
daß die andere Komponente (B) von der epitaktisch aufwachsenden Schicht zur Mitte des Übergangsbereiches hin mit zunehmender Größe der Präzipitate abgeschieden wird.

6. Verfahren nach einem der Ansprüche 3, 4 oder 5,
**dadurch gekennzeichnet,**
daß Konzentration (Dichte) und Größenverteilung der Präzipitate im Konzentrationsmaximum der anderen Komponente (B) vor oder während der Temperung die Perkolationsschwelle überschreiten.

7. Verfahren nach einem der Ansprüche 1 bis 6,
**dadurch gekennzeichnet,**
daß die Abscheidetemperatur zur Erzeugung größerer oder kleinerer Präzipitate variiert wird.

8. Verfahren nach einem der Ansprüche 1 bis 7,
**dadurch gekennzeichnet,**
daß die Abscheiderate zur Erzeugung zunehmender oder abnehmender Konzentration der stabilen oder metastabilen Phase variiert wird.

9. Verfahren nach einem der vorhergehenden Ansprüche,
**dadurch gekennzeichnet,**
daß die Zunahme oder Abnahme der Größenverteilung der Präzipitate und/oder deren Konzentration kontinuierlich oder in Stufen vorgenommen wird.

10. Verfahren nach einem der vorhergehenden Ansprüche,
**dadurch gekennzeichnet,**
daß zusätzlich Dotierungsstoffe abgeschieden werden.

11. Schichtsystem aus wenigstens drei Schichten mit einkristallinen Si-Schichten in ungerader Folge, wobei die erste Si-Schicht auf einem geeigneten Substrat aufgewachsen ist,
**dadurch gekennzeichnet,**
daß ab der zweiten Schicht von je zwei aneinander anliegenden Schichten die einkristalline Si-Schicht eine Versetzungsdichte von maximal 10⁴ cm⁻² aufweist.

12. Mehrfachschichtsystem aus wenigstens vier Schichten aus halbleitenden, metallischen oder isolierenden Materialien mit einkristallinen Schichten in ungerader Folge,
**dadurch gekennzeichnet,**
daß ab der dritten Schicht von je zwei aneinander anliegenden Schichten mindestens eine der Schichten eine einkristalline Struktur aufweist, die für elektronische, elektrooptische, optische oder magnetische Bauelemente geeignet ist.

## Claims

1. Process for producing a layer system of at least two layers of semiconducting, metallic or insulating materials, in which a first material component (A), for forming the lowest, monocrystalline layer, is deposited on a suitable substrate and further components for forming further layers are then deposited on the respective preceding layer, characterized in that, in the case of two layers lying on one another, at least one of which grows epitaxially, the component forming the epitaxial layer and the other component (B) forming the other layer, which components are not completely soluble in one another, are deposited together in a transition region which partly covers the layer (A) which grows epitaxially and fully covers the other layer, the other component (B) alone or both components (A and B) together forming a stable or metastable phase at the deposition temperature and the volume proportion of the other component (B) being present in a sub-stoichiometric quantity and both components being proportioned in their volume concentration or their concentration gradient with respect to the transition region such that precipitates of the stable and metastable phase form in the epitaxial layer of the transition region, and in that, during subsequent annealing at a temperature at which sufficient solubility and a sufficient diffusion constant of the other component (B) in the epitaxial matrix are produced, diffusive redistribution of the stable phase occurs, in which, by coalescence of the precipitates, the separate layers, lying on one another, are produced, the other of which is formed from the stable phase or from a stable phase produced from the metastable phase.

2. Process according to Claim 1, characterized in that the component (A) forming the layer which grows epitaxially is partly or completely supplemented during the common deposition of the components by another component (C) which likewise forms a layer which grows epitaxially.

3. Process according to Claim 1 or 2, characterized in that the transition region is dimensioned taking into account the diffusion lengths of the diffusing component (B).

4. Process according to Claim 3, characterized in that the other component (B) is deposited, with increasing concentration towards the middle of the transition region, by the layer (A or C) which grows epitaxially.

5. Process according to Claim 3, characterized in that the other component (B) is deposited, with increasing size of the precipitates towards the middle of the transition region, by the layer which grows epitaxially.

6. Process according to one of Claims 3, 4 or 5, characterized in that the concentration (density) and size distribution of the precipitates at the concentration maximum of the other component (B) exceed the percolation threshold before or during the heat treatment.

7. Process according to one of Claims 1 to 6, characterized in that the deposition temperature is varied in order to produce larger or smaller precipitates.

8. Process according to one of Claims 1 to 7, characterized in that the deposition rate is varied in order to produce increasing or decreasing concentration of the stable or metastable phase.

9. Process according to one of the preceding claims, characterized in that the increase or decrease in the size distribution of the precipitates and/or their concentration is carried out continuously or in stages.

10. Process according to one of the preceding claims, characterized in that additional dopants are deposited.

11. Layer system of at least three layers having monocrystalline Si layers in an odd numbered sequence, the first Si layer being grown on a suitable substrate, characterized in that, from the second layer of in each case two layers lying on one another, the monocrystalline Si layer has a dislocation density of at most 10⁴ cm⁻².

12. Multilayer system of at least four layers of semiconducting, metallic or insulating materials having monocrystalline layers in an odd-numbered sequence, characterized in that, from the third layer of in each case two layers lying on one another, at least one of the layers has a monocrystalline structure which is suitable for electronic, opto-electronic, optical or magnetic components.

## Revendications

1. Procédé de fabrication d'un système stratifié formé d'au moins deux couches de matériaux semiconducteurs, métalliques ou isolants, dans lequel un premier composant de matériau (A) servant à la formation de la couche inférieure monocristalline est déposé sur un substrat approprié, et ensuite, d'autres composants servant à la formation des couches supplémentaires sont déposés sur la couche précédente respective,
caractérisé en ce que, dans le cas de deux couches contiguës dont au moins une couche est à croissance épitaxiale, le composant formant la couche épitaxiale et l'autre composant (B) formant l'autre couche, qui ne sont pas complètement solubles l'un dans l'autre, sont déposés ensemble dans une zone de transition contenant une partie de la couche (A) à croissance épitaxiale et l'ensemble de l'autre couche, l'autre composant (B) seul ou les deux composants (A et B) ensemble formant une phase stable ou métastable à la température de déposition, la proportion en volume de l'autre composant (B) étant inférieure à la quantité stoechiométrique, et les deux composants étant dosés, en ce qui concerne leur concentration en volume ou leur gradient de concentration se rapportant à la zone de transition, d'une manière telle que des précipités de la phase stable ou de la phase métastable sont formés dans la couche épitaxiale de la zone de transition, et en ce que, pendant une opération subséquente de recuit à une température à laquelle s'établissent une solubilité suffisante et une constante de diffusion de l'autre composant (B) dans la matrice épitaxiale, une redistribution par diffusion de la phase stable apparaît, pendant laquelle les couches contiguës séparées sont formées par coalescence des précipités, dont l'autre couche est formée par la phase stable ou la phase stable formée à partir de la phase métastable.

2. Procédé selon la revendication 1, caractérisé en ce que le composant (A) formant la phase à croissance épitaxiale est complété partiellement ou entièrement, pendant le dépôt commun des composants, par un autre composant (C) formant aussi une couche à croissance épitaxiale.

3. Procédé selon la revendication 1 ou 2, caractérisé en ce qu'on choisit les dimensions de la zone de transition en prenant en considération les longueurs de diffusion du composant (B) diffusant.

4. Procédé selon la revendication 3, caractérisé en ce que l'autre composant (B) est déposé à partir de la couche à croissance épitaxiale (A ou C) jusqu'au milieu de la zone de transition, avec une concentration croissante.

5. Procédé selon la revendication 3, caractérisé en ce que l'autre composant (B) est déposé à partir de la couche à croissance épitaxiale jusqu'au milieu de la zone de transition, avec une dimension croissante des précipités.

6. Procédé selon l'une des revendications 3, 4 ou 5, caractérisé en ce que la concentration (densité) et la répartition dimensionnelle des précipités à la concentration maximale de l'autre composant (B) avant ou pendant le recuit dépassent le seuil de percolation.

7. Procédé selon l'une des revendications 1 à 6, caractérisé en ce qu'on fait varier la température de déposition pour produire des précipités plus gros ou plus petits.

8. Procédé selon l'une des revendications 1 à 7, caractérisé en ce qu'on fait varier la vitesse de déposition pour produire une concentration croissante ou décroissante de la phase stable ou de la phase métastable.

9. Procédé selon l'une des revendications précédentes, caractérisé en ce qu'on effectue l'augmentation ou la diminution de la répartition dimensionnelle des précipités et/ou leur concentration en continu ou par étapes.

10. Procédé selon l'une des revendications précédentes, caractérisé en ce qu'on dépose, en outre, des dopants.

11. Système stratifié formé d'au moins trois couches avec des couches monocristallines de Si dans un ordre impair, la première couche de Si étant développée sur un substrat approprié, caractérisé en ce qu'à partir de la deuxième couche, la couche monocristalline de Si de chaque paire de couches contiguës présente une densité maximale de dislocation de 10⁴ cm⁻².

12. Système multicouche formé d'au moins quatre couches de matériaux semiconducteurs, métalliques ou isolants avec des couches monocristallines dans un ordre impair, caractérisé en ce qu'à partir de la troisième couche, dans chaque paire de couches contiguës, au moins une des couches présente une structure monocristalline qui est appropriée à des composants électroniques, électro-optiques, optiques ou magnétiques.
